(19) Europäisches Patentamt
European Patent Office
Office européen des brevets

(11) **EP 0 908 891 B1**

(12) **EUROPÄISCHE PATENTSCHRIFT**

(45) Veröffentlichungstag und Bekanntmachung des Hinweises auf die Patenterteilung:
**09.07.2003 Patentblatt 2003/28**

(51) Int Cl.⁷: **G11C 8/00**

(21) Anmeldenummer: **98116676.2**

(22) Anmeldetag: **03.09.1998**

(54) **Schaltungsanordnung zur Behandlung von Zugriffskonflikten**

Circuit for processing access conflicts

Circuit de traitement de conflits d'accès

(84) Benannte Vertragsstaaten:
**DE FR GB IT**

(30) Priorität: **16.09.1997 DE 19740694**

(43) Veröffentlichungstag der Anmeldung:
**14.04.1999 Patentblatt 1999/15**

(73) Patentinhaber: **Infineon Technologies AG**
**81669 München (DE)**

(72) Erfinder: **Mattausch, Hans-Jürgen, Prof.**
**Higashi-Hiroshima, 739-8527 (JP)**

(74) Vertreter: **Barth, Stephan Manuel, Dr. et al**
**Reinhard-Skuhra-Weise & Partner Gbr,**
**Patentanwälte**
**Friedrichstrasse 31**
**80801 München (DE)**

(56) Entgegenhaltungen:
**EP-A- 0 620 533          US-A- 5 062 081**
**US-A- 5 289 427          US-A- 5 434 818**

**Beschreibung**

Die Erfindung betrifft eine Schaltungsanordnung zur Behandlung von Zugriffskonflikten bei Speichern mit einer Mehrzahl von voneinander unabhängigen, gleichzeitig parallel adressierbaren I/O-Ports, wie aus der US-A-5,289,427 bekannt.

Die US-A-5,062,081 offenbart die Verwendung von Multi-Input-EXOR-Gattern zum Adressenvergleich.

Künftige mikroelektronische Schaltungen werden komplizierte Systeme mit Transistorenzahlen im Bereich von $10^{12}$ bis $10^{15}$ realisieren. Diese Systeme, wie zum Beispiel Parallelprozessorsysteme, Systeme der künstlichen Intelligenz oder Multimediasysteme, werden in der Regel mehrere kooperierende Subsysteme zur Verarbeitung von Daten enthalten. Ein entscheidendes Problem für die effiziente praktische Realisierung dieser künftigen Systeme wird somit die Speicherung der zu verarbeitenden Daten sowie der Datenverarbeitungsprogramme sein. Die leistungsfähigsten Systeme werden sich sicherlich dann realisieren lassen, wenn ein Speicher zur Verfügung steht, auf den die Subsysteme zeitlich parallel und mit hoher Bandbreite zugreifen können.

Eine attraktive Lösung dieses Problems ist die Verwendung von sogenannten Multi-Port-Speichern, die eine Vielzahl von unabhängigen Anschlußports aufweisen, auf die externe Baugruppen zeitlich parallel zugreifen können.

In allen Multi-Port-Speichern mit unabhängig adressierbaren Ports kann es jedoch zu Zugriffskonflikten kommen. Ein Zugriffskonflikt entsteht, wenn gleichzeitig zwei oder mehr Ports auf dieselbe Speicherzelle zugreifen wollen. Ob ein solcher Zugriffskonflikt nur bei Schreibvorgängen oder auch bei Schreib/Lesevorgängen entsteht, hängt von der gewählten Speicherarchitektur ab. Bei konventionellen Multi-Port-Speichern, bei denen alle Anschlußports in jeder der Speicherzellen implementiert ist, entsteht ein Zugriffskonflikt ausschließlich beim einem Schreibzugriff. Bei Multi-Port-Speichern, die 1-Port-Speicherzellen aufweisen, wie beispielsweise ein sogenanntes Switching-Network oder eine hierarchisch aufgebaute Speicherarchitektur, entsteht ein Zugriffskonflikt sowohl bei einem Schreibzugriff als auch bei einem Lesezugriff.

Das beschriebene Problem des Zugriffskonflikts hat sich bisher kaum gestellt, da Multi-Port-Speicher mit voneinander unabhängig adressierbaren Ports in integrierten Systemen bisher kaum eingesetzt wurden.

In Systemen, in denen trotzdem Multi-Port-Speicher verwendet wurde, wurde ein Zugriffskonflikt üblicherweise auf der Systemseite gelöst. Das bedeutet, ein Zugriffskonflikt wurde von dem System, in dem sich der Multi-Port-Speicher befindet erkannt und programmspezifisch wurde eine Zuordnung der Daten für jeden Port getroffen. Der Speicher selbst verfügte somit über keine eigenen Mittel zur Behandlung von Zugriffskonflikten. Somit war zusätzlicher Schaltungsaufwand bzw. Programmieraufwand auf der Systemseite zum Betreiben eines derartigen Multi-Port-Speichers notwendig.

In einem weiteren Ansatz zur Behandlung von Zugriffskonflikten bei Multi-Port-Speichern wurden die unterschiedlichen excernen Anschlußports intern auf einen einzigen Port geschaltet. Bei einem Zugriffskonflikt, der dann bei gleichzeitigem Zugriff von mehreren Ports immer auftritt, wurden die Daten sequentiell, beispielsweise durch einen einfachen Multiplexer und einen kleinen Pufferspeicher, über den einzigen internen Anschlußport abgearbeitet. Ein derartiger Multi-Port-Speicher weist somit jedoch das Betriebsverhalten eines 1-Port-Speichers auf.

Ausgehend von diesem Stand der Technik liegt daher der Erfindung die Aufgabe zugrunde, eine einfache zu verschaltende Schaltungsanordnung zur Behandlung von Zugriffskonflikten bei Multi-Port-Speichern anzugeben.

Erfindungsgemäß wird die Aufgabe gelöst durch eine Schaltungsanordnung nach Anspruch 1.

Die erfindungsgemäße Schaltungsanordnung zur Behandlung von Zugriffskonflikten ist dabei als Teilschaltung in einem Multi-Port-Speicher enthalten. Im Falle eines Zugriffskonflikts von zwei oder mehr Ports entscheidet die Schaltungsanordnung zur Behandlung von Zugriffskonflikten, von welchem Port der Zugriff erfolgen kann und für welchen Port bzw. welche Ports der Zugriff zurückgewiesen wird.

Die Schaltungsanordnung zur Behandlung von Zugriffskonflikten besteht dabei aus zwei Teilschaltungen: der sogenannten Konflikterkennungsschaltung und der sogenannten Zugriffssperrschaltung.

Die Konflikterkennungsschaltung erkennt einen Zugriffskonflikt und gibt ein erstes Statussignal aus, welches angibt, zwischen welchen Ports ein Zugriffskonflikt besteht. Diese Statussignal wird in die nachgeschaltete Konfliktsperrschaltung eingekoppelt. Die Konfliktsperrschaltung weist jedem der Ports, die an dem Zugriffskonflikt beteiligt sind, eine Priorität zu. Ausgehend von dieser Priorisierung wird das am höchsten priorisierte Port freigegeben während die übrigen Ports gesperrt werden. Der Status jedes Ports, das heißt, ob der jeweilige Zugriff erfolgreich war oder nicht, wird in einem zweiten Statussignal für das gesamte System, in dem sich der Multi-Port-Speicher befindet, angezeigt.

Die Priorisierung läuft dabei nach einem vorgegebenen Algorithmus ab. Dieser Priorisierungsalgorithmus ist bevorzugt in der Konfliktsperrschaltung implementiert. Erfindungsgemäß kann dabei ein einfacher sogenannter PIH-Algorithmus oder ein "fairer" sogenannter IPIH-Algorithmus zur Priorisierung der am Zugriffskonflikt beteiligten Ports verwendet werden.

Die Erfindung wird nachfolgend anhand der in den Figuren der Zeichnung angegebenen Ausführungsbeispiele näher erläutert. Es zeigt dabei:

Figur 1     das Blockschaltbild einer erfindungsgemäßen Anordnung zur Behandlung von Zugriffskonflikten bei Multi-Port-Speichern;

Figur 2     ein Ausführungsbeispiel einer erfindungsgemäßen Zugriffserkennungsschaltung, die im vorliegenden Beispiel mit N=4 Ports angegeben ist;

Figur 3     die Darstellung eines Multi-Input EXOR-Gatters in ($\alpha$) symbolischer Darstellung und ($\beta$) als Ausführungsbeispiel im Falle m=4;

Figur 4     eine Schaltungsanordnung zur Realisierung des PIH-Algorithmus im Falle von N=4 Ports;

Figur 5     eine Schaltungsanordnung zur Realisierung des IPIH-Algorithmus im Falle von N=4 Ports.

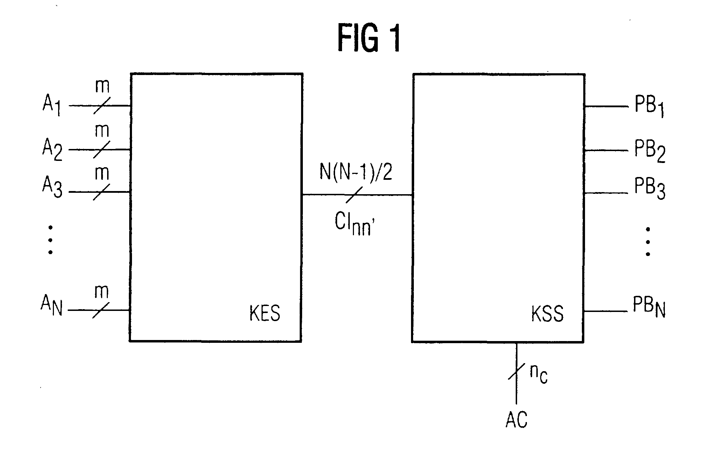

Figur 1 zeigt das Blockschaltbild einer erfindungsgemäßen Schaltungsanordnung zur Behandlung von Zugriffskonflikten, die im wesentlichen aus einer Konflikterkennungsschaltung KES und einer nachgeschalteten Konfliktsperrschaltung KSS bestehen.

Am Eingang der Schaltungsanordnung zur Behandlung von Zugriffskonflikten und somit der Konflikterkennungsschaltung KES sind N verschiedene Adreßleitungen vorgesehen, wobei N die Anzahl der Anschlußports des Multi-Port-Speichers angibt. Jede Adreßleitungen weist jeweils eine Adresse A1 - AN mit jeweils m-Adreßbits auf.

In der Konflikterkennungsschaltung KES wird zur Feststellung von Konfliktsituationen ein paarweiser Vergleich der Adreßbits A1 - AN durchgeführt. Die Konflikterkennungsschaltung KES erzeugt ausgangsseitig ein Statussignal Clnn', wobei n die Werte n=1 bis n-1 und n' die Werte n'=1 bis N annehmen kann. Insgesamt hat damit das Statussignal Clnn' im Falle von N-verschiedenen Ports genau N*(N-1)/2 verschiedene Signalleitungen. Der Index nn' des Statussignals Clnn' bezeichnet dabei einen Zugriffskonflikt zweier beteiligter Ports. Bespielsweise bezeichnet ein Statussignal $CL_{35}$ einen Zugriffskonflikt zwischen dem 3. Port und dem 5. Port.

Prinzipiell könnten die Statussignale Clnn' auch in codierter Form mit weniger Signalleitungen zwischen der Konflikterkennungsschaltung KES und der Zugriffssperrschaltung KSS übertragen werden. Dies erfordert allerdings einen erheblichen Codierungs- und Decodierungsaufwand und ist somit schaltungstechnisch insbesondere bei einer Implementierung dieser Schaltung in einer integrierten Schaltung äußerst flächenaufwendig.

Das Statussignal Clnn' wird in den Eingang der Zugriffssperrschaltung KSS eingekoppelt. Die Zugriffssperrschaltung KSS führt dann einen Algorithmus zur Lösung eines auftretenden Zugriffskonflikts aus. Die an dem Zugriffskonflikt beteiligten Ports werden nach ihrer Priorität bewertet. Dabei erhält der am höchsten priorisierte Port das Zugriffsrecht und den übrigen am Zugriffskonflikt beteiligten Ports wird der Zugriff verweigert.

Zusätzlich kann in der Konfliktsperrschaltung KSS ein Algorithmussteuersignal AC vorgesehen sein, welches nc-Steuerbits aufweist.

Am Ausgang der Konfliktsperrschaltung KSS sind N verschiedene Ausgangsleitungen vorgesehen. Jeder dieser Ausgangsleitungen ist ein Portsperrsignal PB1 - PBN für jedes der N Ports des Multi-Port-Speichers zugeordnet. Hierbei wird die Logik PBi=0 (i = 1... N) für die Zugriffserlaubnis und PBi=1 für die Zugriffsverweigerung verwendet. Natürlich kann auch eine invertierte Logik für die Portsperrsignale PB1 - PBN verwendet werden.

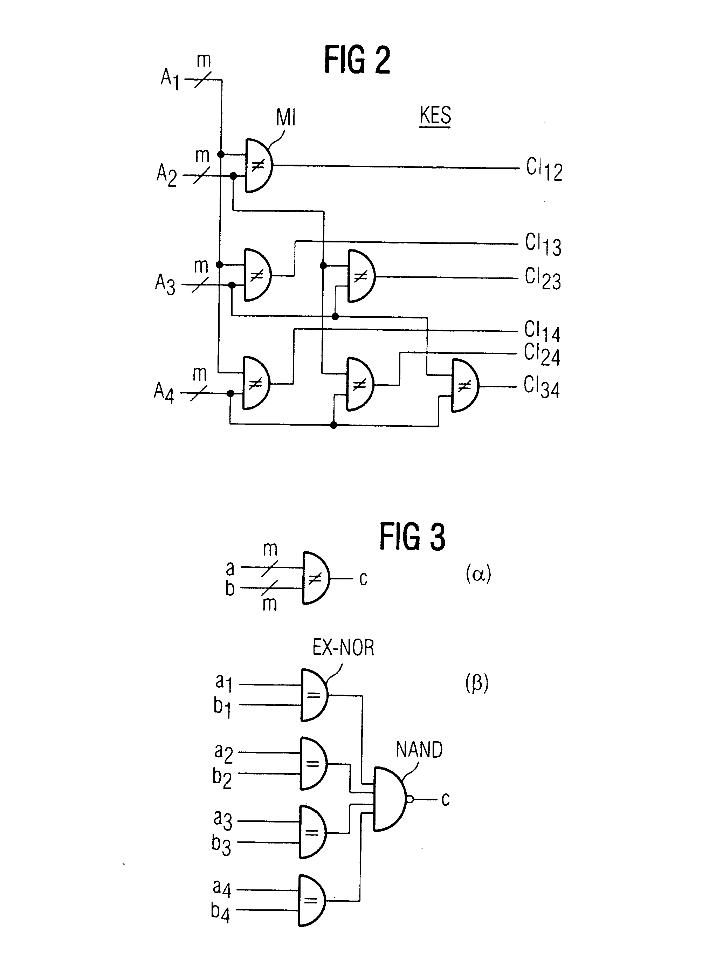

Figur 2 zeigt ein Ausführungsbeispiel für eine erfindungsgemäße Konflikterkennungsschaltung KES, die im vorliegenden Beispiel mit N=4 Ports angegeben ist. Dabei wurden gleiche bzw. funktionsgleiche Elemente entsprechend Figur 1 mit gleichen Bezugszeichen versehen.

Die Konflikterkennungsschaltung KES weist N = 4 Adreßports mit den Adreßsignalen A1 - A4 mit jeweils m-Adreßbits auf. Entsprechend der obigen Beziehung weist die Konflikterkennungsschaltung KES dann N*(N-1)/2 = 6 Ausgangsleitungen mit den entsprechenden Statussignalen Clnn' auf. Jedes dieser Statussignale Clnn' wird dabei ausgangsseitig von einem sogenannten Multi-Input EXOR-Gatter MI erzeugt. Die Anzahl der Multi-Input EXOR-Gatter MI errechnet sich dabei ebenfalls aus der Beziehung N*(N-1)/2. Die Multi-Input EXOR-Gatter MI sind in N-1 verschiedenen Reihen angeordnet. Für jedes zusätzliche Port kommt somit eine weitere Reihe von Multi-Input EXOR-Gatter MI hinzu und es werden ebenfalls eine entsprechende Anzahl weitere Statussignale Clnn' erzeugt. Falls kein Zugriffskonflikt auftritt, sind alle Statussignale Clnn'=1. Ein auftretender Zugriffskonflikt wird dadurch angezeigt, daß eines oder mehrere der Statussignale Clnn'=0 gesetzt sind.

Die Multi-Input EXOR-Gatter MI in Figur 2 sind vereinfacht dargestellt. Die exakte Gatterschaltung eines derartigen Multi-Input EXOR-Gatters MI wird nachfolgend in Figur 3 genauer dargestellt. Dabei sind gleiche bzw. funktionsgleiche Elemente entsprechend der vorhergehenden Figuren mit gleichen Bezugszeichen und gleicher Indizierung versehen.

Teilfigur ($\alpha$) in Figur 3 zeigt nochmals das hier allgemein verwendete Symbol für ein Multi-Input-EXOR-Gatter MI, wobei m die Anzahl der Inputs der Gatterschaltung darstellt. Mit a und b sind die Eingangssignale und mit c das Ausgangssignal bezeichnet. Teilfigur ($\beta$) zeigt ein Ausführungsbeispiel eines derartigen Multi-Input-EXOR-Gatter MI für den Fall m=4. Für jeden der vier Eingänge wird hier ein konventionelles EX-NOR-Gatter benötigt. Ein NAND-Gatter verknüpft anschließend alle Ausgänge dieser EX-NOR-Gatter und erzeugt am Ausgang das Ausgangssignal c.

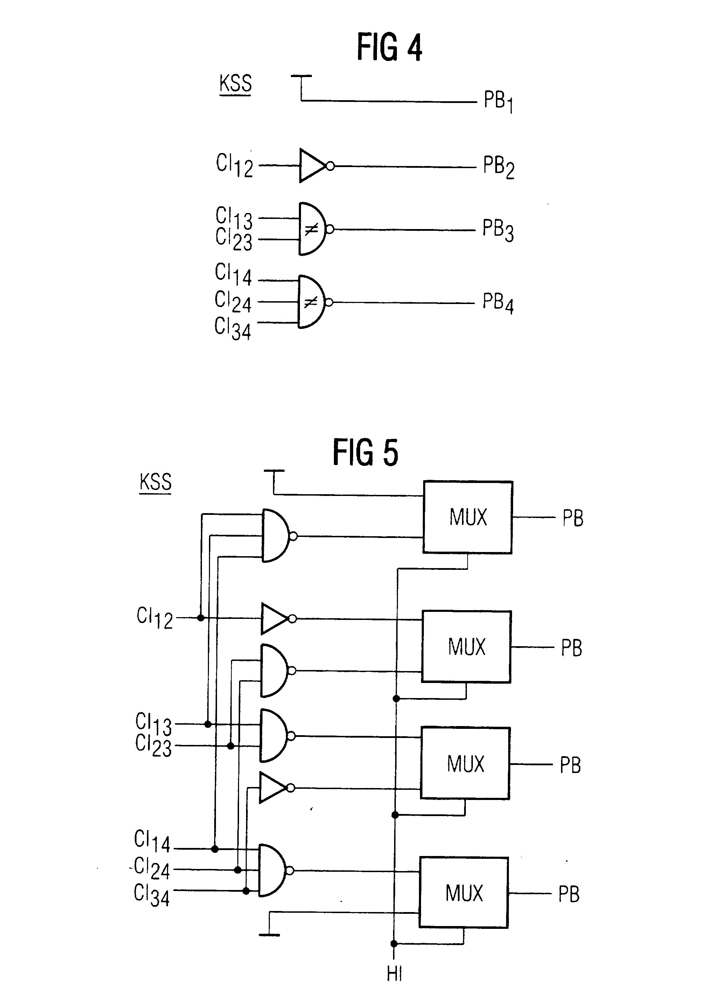

Nachfolgend wird anhand von Figuren 4 und 5 die Funktionsweise der erfindungsgemäßen Zugriffssperrschaltung KSS ausgehend von dem Ausführungsbeispiel in Figur 2 erläutert. Dabei werden zwei Ausführungsbeispiele vorgestellt, die anhand zweier unterschiedlicher Priorisierungsalgorithmen die Behandlung bei einem Zugriffskonflikt vornehmen. Die Bezeichnung der verschiedenen Elemente bzw. deren Indizierung wurde von den Figuren 1 und 2 übernommen.

Der erste Algorithmus entsprechend Figur 4 wird allgemein als PIH-Algorithmus (Port Importance Hierachy Algorithmus) bezeichnet. Bei dem PIH-Algorithmus wird eine Rangfolge der Bedeutung der Ports festgelegt. Beispielsweise wird eine Rangfolge derart festgelegt, daß Port 1 bedeutender ist als Port 2, daß Port 2 wiederum bedeutender ist als Port 3, usw.. Das Port mit der geringsten Bedeutung ist dann schließlich das Port N. Man kann dies auch unter Verwendung des >-Zeichens als Symbol für die höhere Bedeutung in der nachfolgenden Form darstellen:

$$\text{Port 1} > \text{Port 2} > \text{Port 3} > ... > \text{Port N}$$

Ein Konfliktfall wird immer dann so gelöst, daß das beteiligte Port mit der höchsten Bedeutung das Zugriffsrecht erhält und daß für alle anderen beteiligten Ports der Zugriff verweigert wird. Insbesondere dem Port N wird bei diesem PIH-Algorithmus in jedem Zugriffskonfliktfall, an dem es beteiligt ist, der Zugriff verweigert.

Der PIH-Algorithmus weist den Vorteil auf, daß er mit der einfachen, in Figur 4 gezeigten Schaltungsanordnung realisiert werden kann. Diese Schaltungsanordnung weist einfache NAND-Gatter auf. Für einen gegebenen Port i werden bei dem PIH-Algorithmus auf einfache Weise die Statussignale Clnn', die einen Konflikt von Port i mit einem Port höherer Priorität signalisieren, mit einer NAND-Funktion verknüpft. Falls eines der Statussignale 0 wird, das heißt, wenn ein Zugriffskonflikt mit einem Port höherer Priorität auftritt, wird ein Portsperrsignal PBi=1 erzeugt, was wiederum bedeutet, daß dem Port i der Zugriff verweigert wird.

Für manche Systemanforderungen kann die Tatsache der unterschiedlichen Rückweisungswahrscheinlichkeit einer Zugriffsanforderung von den verschiedenen Ports des Multi-Port-Speichers, wie es beim PIH-Algorithmus der Fall ist, ein nicht tolerierbarer Nachteil sein. In diesem Fall ist ein Algorithmus vorzuziehen, der eine gleich große Wahrscheinlichkeit für den Zugriff von jedem Port realisiert. Ein derartiger Algorithmus wird allgemein auch als "fairer" Algorithmus bezeichnet.

In Figur 5 ist ein Ausführungsbeispiel einer Zugriffssperrschaltung angegeben, die auf einfache Weise einen derartigen "fairen" Algorithmus realisiert. Nachfolgend wird dieser "faire" Algorithmus auch als IPIH-Algorithmus (Inverted Port Importance Hierarchy Algorithmus) bezeichnet. Bei dem IPIH-Algorithmus wird der Zugriff alterniert sowie nach einer gegebenen Porthierarchie und der dazu invertierten Porthierarchie geregelt. Dabei wird jeweils ein Ausgangssignal für die gegebene Porthierarchie und ein Ausgangssignal für die dazu invertierte Porthierarchie jeweils einer Multiplexerschaltung MUX zugeführt. Im vorliegenden Beispiel besteht die Multiplexerschaltung MUX aus einem einfachen Multiplexer, der aus den zwei Eingangssignalen eines auswählt. Dieses Auswahlsignal wird dann am Ausgang als Portsperrsignal PB1 - PB4 bereit gestellt. Der alternierende Wechsel wird durch das Hierarchieinversionssignal HI, das beispielsweise das Algorithmussignal aus Figur 1 sein kann, gesteuert. Die Zugriffswahrscheinlichkeit wird dadurch im Mittel für jedes Port gleich groß.

Konkret wird beim IPIH-Algorithmus zwischen der normalen Hierarchie (entsprechend dem IPH-Algorithmus) des entsprechenden Ports nach der Beziehung

$$\text{Port 1} > \text{Port 2} > \text{Port 3} > ... > \text{Port N}$$

und dazu invertierten Hierarchie

$$\text{Port N} > \text{Port (N-1)} > \text{Port (N-2)} > ... > \text{Port 2} > \text{Port 1}$$

bei der Lösung von Konfliktfällen gewechselt.

Der Wechsel wird durch das Hierarchieinversionssignal HI gesteuert. Der Wechsel kann bei jedem Zugriffszyklus oder nach jeweils einer festen Anzahl von Zugriffszyklen erfolgen und wird bei synchronen Speichern typischerweise aus dem Taktsignal abgeleitet. Auf diese Weise entsteht eine im Mittel gleiche Zugriffswahrscheinlichkeit für jedes Port.

Es wären selbstverständlich auch andere Algorithmen zur Behandlung von Zugriffskonflikten denkbar. Die oben beschriebene ist jedoch eine Möglichkeit auf einfache Weise und schaltungstechnisch mit geringem Aufwand eine parallele Behandlung von Zugriffskonflikten bei Multi-Port-Speichern zu erzielen.

Besonders vorteilhaft ist die Erfindung, wenn die Schaltungsanordnung zur Behandlung von Zugriffskonflikten in einer aus Multi-Port-Speicherzellen aufgebauten Speicherarchitektur verwendet wird. Dabei kann diese Speicherarchitektur in einer sogenannten Mehrebenenhierachie aufgebaut sein. Darüber hinaus ist jedoch die Schaltungsanordnung auch vorteilhafterweise einsetzbar in einem nach dem Switching-Network-Prinzip arbeitenden Multi-Port-Speicherarchitektur.

**Patentansprüche**

1. Schaltungsanordnung zur Behandlung von Zugriffskonflikten bei Speichern mit einer Mehrzahl von N voneinander unabhängigen, gleichzeitig parallel adressierbaren I/O-Ports, wobei

- mindestens eine Konflikterkennungsschaltung (KES) vorgesehen ist, die einen Zugriffskonflikt einer Mehrzahl von I/O-Ports auf dieselbe Speicherzelle des Speichers erkennt, und
- mindestens eine nachgeschaltete Konfliktsperrschaltung (KSS) vorgesehen ist, die im Falle eines Zugriffskonflikts einer Mehrzahl von I/O-Ports auf dieselbe Speicherzelle über N Ausgabesignale (PB1 - PBN) einen am Zugriffskonflikt beteiligten I/O-Port freigibt und die übrigen am Zugriffskonflikt beteiligten I/O-Ports sperrt,

**dadurch gekennzeichnet,**
**daß**
die Konflikterkennungsschaltung (KES) ein Statussignal (Clnn') auf N · (N-1)/2 Signalleitungen erzeugt, das der Konfliktsperrschaltung (KSS) zugeführt wird , wobei das Statussignal angibt, zwischen welchen I/O-Ports ein Zugriffskonflikt besteht, in der Konflikterkennungsschaltung (KES) N · (N-1)/2 Multi-Input-EXOR-Gatter (MI) vorgesehen sind, die zur Erzeugung des Statussignals (Clnn') eine logische Verknüpfung der Adressen der N I/O-Ports vornehmen, Wobei die Konflikterkennungsschaltung (KES) zur Feststellung von Konfliktsituationen einen paar weisen Vergleich der Adressbits dieser Adressen durchführt.

2. Schaltungsanordnung nach Anspruch 1,
**dadurch gekennzeichnet,**
**daß** die Zugriffssperrschaltung (KSS) eine Priorisierung der I/O-Ports entsprechend ihrer Bedeutung nach einem Priorisierungsalgorithmus vornimmt.

3. Schaltungsanordnung nach Anspruch 2,
**dadurch gekennzeichnet,**
**daß** als Priorisierungsalgorithmus der PIH-Algorithmus verwendet wird.

4. Schaltungsanordnung nach Anspruch 2,
**dadurch gekennzeichnet,**
**daß** als Priorisierungsalgorithmus der IPIH-Algorithmus verwendet wird.

5. Schaltungsanordnung nach einem der vorhergehenden Ansprüche in einer in Mehrebenen-Hierarchie aufgebauten Speicherarchitektur.

6. Schaltungsanordnung nach einem der vorhergehenden Ansprüche in einer aus Multi-Port-Speicherzellen aufgebauten Speicherarchitektur.

7. Schaltungsanordnung nach einem der vorhergehenden Ansprüche in einem nach dem Switching-Network-Prinzip arbeitende Multi-Port-Speicherarchitektur.

**Claims**

1. Circuit arrangement for handling access contentions in the case of memories having a plurality of N mutually independent I/O ports which can be addressed simultaneously in parallel,

- at least one contention identification circuit (KES) being provided which identifies an access contention between a plurality of I/O ports to the same memory cell of the memory, and
- at least one contention inhibit circuit (KSS) connected downstream being provided which, in the event of an access contention between a plurality of I/O ports to the same memory cell, uses N output signals (PB1 - PBN) to enable one I/O port involved in the access contention and to inhibit the remaining I/O ports involved in the access contention,

**characterized**
**in that**
the contention identification circuit (KES) generates a status signal (Cinn') on N · (N-1)/2 signal lines which is fed to the contention inhibit circuit (KSS), the status signal specifying the I/O ports between which an access contention exists,
N · (N-1)/2 multi-input EXOR gates (MI) are provided in the contention identification circuit (KES), which gates perform logic combination of the addresses of the N I/O ports for the purpose of generating the status signal (Clnn'),
the contention identification circuit (KES) carrying out a pair-by-pair comparison of the address bits of these addresses in order to ascertain contention situations.

2. Circuit arrangement according to Claim 1,
**characterized**
**in that**
the access inhibit circuit (KSS) performs prioritization of the I/O ports in a manner corresponding to their importance according to a prioritization algorithm.

3. Circuit arrangement according to Claim 2,
**characterized**
**in that**
the PIH algorithm is used as the prioritization algorithm.

4. Circuit arrangement according to Claim 2,
**characterized**

**in that**
the IPIH algorithm is used as the prioritization algorithm.

5. Circuit arrangement according to one of the preceding claims in a memory architecture constructed in a multi-level hierarchy.

6. Circuit arrangement according to one of the preceding claims in a memory architecture constructed from multi-port memory cells.

7. Circuit arrangement according to one of the preceding claims in a multi-port memory architecture operating according to the switching network principle.

**Revendications**

1. Dispositif de circuit de traitement de conflits d'accès dans le cas de mémoires comportant avec une multiplicité de N ports E/S indépendants les uns des autres, adressables de façon parallèle simultanément, dans lequel :

   - au moins un circuit de détection de conflits (KES) est prévu lequel détecte un conflit d'accès d'uns multiplicité de ports E/S sur la même cellule de mémoire de la mémoire, et
   - au moins un circuit de blocage de conflits (KSS) monté en aval est prévu lequel, dans le cas d'un conflit d'accès d'une multiplicité de ports E/S sur la même cellule de mémoire, libère, via N signaux de sortie (PB1 - PBN), un port E/S participant au conflit d'accès, et bloque les autres ports E/S participant au conflit d'accès,

      **caractérisé en ce que**
      le circuit de détection de conflits (KES) produit, sur $N \cdot (N-1)/2$ lignes de signaux, un signal de statut (Clnn') qui est délivré au circuit de blocage de conflits (KSS), le signal de statut indiquant entre quels ports E/S il existe un conflit d'accès,
      dans le circuit de détection de conflits (KES), il est prévu $N \cdot (N-1)/2$ portes EXOR Multi-Input MI, lesquelles, pour produire le signal de statut (Clnn'), réalisent une liaison logique des adresses des N ports E/S, et **en ce que** le circuit de détection de conflits (KES), pour constater des situations de conflit, exécute une comparaison par paires des bits d'adresse de ces adresses.

2. Dispositif de circuit selon la revendication 1, **caractérisé en ce que** le circuit de blocage de conflits (KSS) effectue un classement par ordre de priorité des ports E/S en fonction de leur signification selon un algorithme de classement par ordre de priorité.

3. Dispositif de circuit selon la revendication 2, **caractérisé en ce que** l'algorithme PIH est utilisé comme algorithme de classement par ordre de priorité.

4. Dispositif de circuit selon la revendication 2, **caractérisé en ce que** l'algorithme IPIH est utilisé comme algorithme de classement par ordre de priorité.

5. Dispositif de circuit selon l'une quelconque des revendications précédentes dans une architecture de mémoire constituée en hiérarchie à plusieurs niveaux.

6. Dispositif de circuit selon l'une quelconque des revendications précédentes dans une architecture de mémoire constituée de cellules de mémoire multi-ports.

7. Dispositif de circuit selon l'une quelconque des revendications précédentes dans une architecture de mémoire multi-port fonctionnant selon le principe de réseau de connexion.

# FIG 1

$A_1$ —— $m$ ——

$A_2$ —— $m$ ——

$A_3$ —— $m$ ——

$\vdots$

$A_N$ —— $m$ ——

KES

$N(N-1)/2$

$CI_{nn'}$

KSS

—— $PB_1$

—— $PB_2$

—— $PB_3$

$\vdots$

—— $PB_N$

$n_C$

AC

# FIG 2

# FIG 3

# FIG 4

# FIG 5